Europäisches Patentamt

European Patent Office

Office européen des brevets

(11) Publication number: **0 119 272**

**B1**

## EUROPEAN PATENT SPECIFICATION

(45) Date of publication of patent specification: **03.05.89**

(51) Int. Cl.⁴: **H 05 K 3/34**

(21) Application number: **82902828.1**

(22) Date of filing: **22.09.82**

(86) International application number:
**PCT/JP82/00382**

(87) International publication number:
**WO 84/01258 29.03.84 Gazette 84/09**

(54) **METHOD AND DEVICE FOR SOLDERING PRINTED BOARD.**

(43) Date of publication of application:
**26.09.84 Bulletin 84/39**

(45) Publication of the grant of the patent:
**03.05.89 Bulletin 89/18**

(84) Designated Contracting States:
**DE FR GB NL** .

(56) References cited:
**JP-B-56 045 703**
**JP-U-50 122 638**
**JP-Y-43 012 378**
**US-A-3 834 015**

(73) Proprietor: **Matsushita Electric Industrial Co.,**
**Ltd.**
**1006, Oaza Kadoma**
**Kadoma-shi Osaka-fu, 571 (JP)**

(72) Inventor: **MURAKAMI, Shuichi**
**47-5, Yamanoue 5-chome Hirakata-shi**
**Osaka-fu 573 (JP)**

Inventor: **MATSUDA, Chuichi**
**6-C48-103, Meitoku 1-chome Neyagawa-shi**
**Osaka-fu 570 (JP)**

Inventor: **MATSUMAE, Tatsuya**
**354-5, Sunouchi Kou Saijyo-shi**
**Ehime-ken 793 (JP)**

Inventor: **YAMASHITA, Kenichi**
**5-33, Nakanishi-cho Niihama-shi**
**Ehime-ken 792 (JP)**

Inventor: **MORI, Mikio**
**4602-11, Funaki Kou**
**Niihama-shi Ehime-ken 792 (JP)**

(74) Representative: **Crawford, Andrew Birkby et al**
**A.A. THORNTON & CO. Northumberland House**
**303-306 High Holborn**
**London WC1V 7LE (GB)**

## Description

### TECHNICAL FIELD

The present invention relates to a soldering device for a printed substrate as the object and, particularly, pertains to a soldering device for a printed substrate or circuit board carrying chip form parts such as resistances and condensers, etc., which have no lead, these chip parts being soldered on printed substrate conductor portions each at its opposite end electrodes. The invention also relates to a method of soldering a printed circuit board as described above.

### BACKGROUND ART

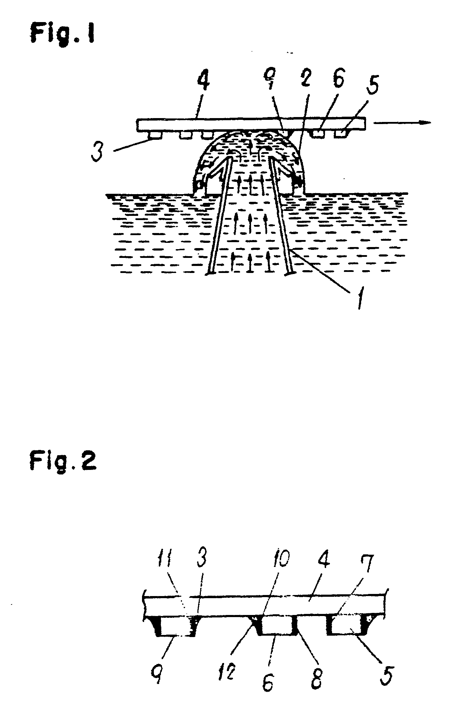

As a soldering device for chip parts, there has been available a jetting soldering device adapted to make soldering by jetting up molten solder onto the surface to be soldered. Fig. 1 shows the commonnest wave form of the jetted solder.

This soldering device involves the following problem:

Thus as shown in Fig. 1, the solder wave 2 is being produced from a nozzle 1, while the printed substrate 4 carrying chip parts 3 is moving from left to right, as seen in this figure, but the solder wave 2 can not enter into a space formed between the chip part 5 and the chip part 6, giving rise to the phenomenon (hereinafter called solderlessness) that no solder can be put on the electrodes 7 and 8 on the chip parts 5 and 6. Since the solder wave 2 can enter into the space between the chip parts 6 and 9 which are widely distance from one another, solder will be deposited on their respective electrodes 10 and 11, forming solder paddings 12 and 13 on the circuit electrodes printed on the substrate 4. To correct the solderlessness which could develop in narrow spaces between the chip parts, it is imperative to provide the solder paddings by manual operation and the local heating by the soldering iron used for the retouching used to inflict damage on these chip parts.

US-A-3834015 discloses a device for soldering printed circuit boards equipped with a solder tank accommodating molten solder, a nozzle for forming a molten solder wave by jetting out molten solder into the solder tank, a printed circuit board conveying means which effects soldering on the printed circuit board by moving the printed circuit board through the molten solder wave and a vibration imparting means for giving a vibration to the printed circuit board. The vibration imparting means is operable to vibrate the circuit board vertically within the tank of molten solder. This vibration is intended to be carried out after a soldering operation in order to remove unwanted "flags" of solder which become adhered to the ends of pins on the circuit board during the soldering operation.

This present invention provides a device for soldering printed circuit boards, said device being equipped with a solder tank accommodating molten solder, a nozzle for forming a molten solder wave by jetting out molten solder from the aforementioned solder tank, a printed circuit board conveying means which effects soldering on the printed circuit board by moving the printed circuit board across the aforementioned molten solder wave, and a vibration imparting means for giving vibration to the aforementioned printed circuit board characterised in that said vibration imparting means is adapted to vibrate said printed circuit board when it is passing across the aforementioned molten solder wave, whereby the solder wave can enter into spaces between chip parts carried on the printed circuit board at a narrow distance from one another.

The present invention also provides a method of soldering a printed circuit board using a soldering device including a solder tank accommodating molten solder, the method comprising:

forming a molten solder wave by jetting molten solder out of the solder tank via a nozzle; and

conveying the printed circuit board across the solder wave to effect soldering on the printed circuit board;

characterised by vibrating the printed circuit board as it is conveyed across the solder wave whereby the solder wave can enter spaces between chip parts carried on the printed circuit board at a narrow distance from each other.

### BRIEF DESCRIPTION OF THE DRAWINGS

FIG. 1 is a schematic view of the conventional soldering device;

FIG. 2 is a side view of the principal portion of the printed substrate, showing the solderlessness in the conventional soldering device;

FIG. 3 is a side view showing the major arrangement of a soldering device embodying this invention;

FIG. 4 is a front view of the same principal portion;

FIG. 5 is a side view of the principal part of the printed substrate on which soldering has been made by use of this device;

FIG. 6 is a plan view of the major arrangement of another soldering device embodying this invention; and

FIG. 7 is a front view of the principal portion of this device.

### THE MOST PREFERABLE MODE IN EXERCISING THIS INVENTION

The present invention will become more apparent from the following detailed description taken in connection with the accompanying drawings:

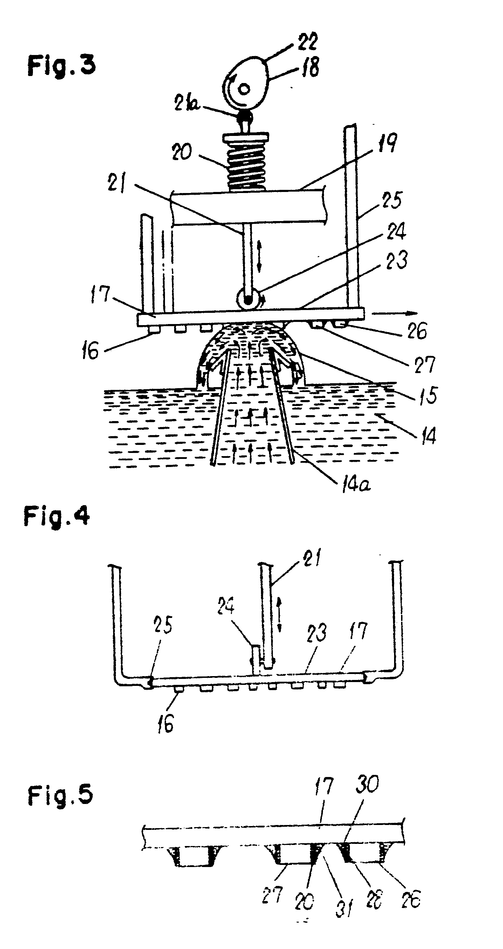

In the embodiment represented by FIG. 3, the solder wave 15 is coming out of nozzle 14a inside the solder tank 14, while the printed substrate carrying chip parts 16 thereon is moving from left to right. On the other hand, upward of the printed substrate 17, there is provided a vibration imparting means in which an offset cam plate 18 turns and, then, the rod 21 which is normally being pushed upward by a spring 20 held in place on the fixed plate 19 is set to make up-down reciprocations through a roller 21a. The up-down motion of the rod 21 will be transmitted to the printed substrate 17 through a roller 24 which is normally in contact with the upper surface 23 of the printed substrate 17; as a result, the printed substrate 17 which is supported by a printed substrate conveying means 25 will be vertically vibrated. On the printed substrate 17 being vibrated in this way, the solder wave 15 will become more apt to enter into narrow spaces between chip parts, so that, as shown in FIG. 5, the solder wave 15 will enter into the space between the chip parts 26 and 27 carried on the printed substrate 17 at a narrow distance from one another, permitting the solder to be deposited on their respective electrodes 28 and 29, thereby forming paddings 30 and 31.

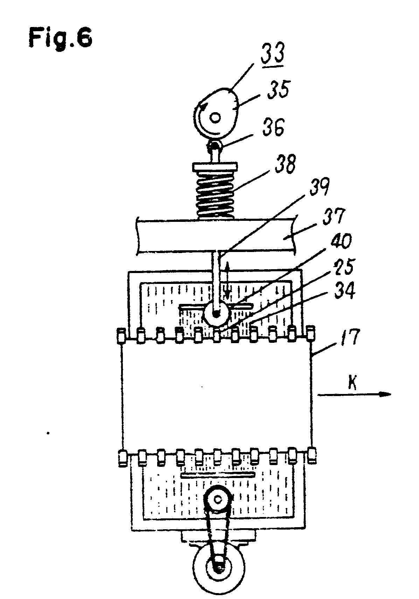

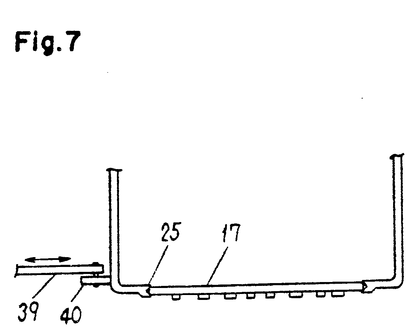

With regard to the way of giving vibration to the printed substrate 17, as shown in FIGS. 6 and 7, similar effect may be achieved by utilizing a vibration imparting means 33 which gives the impact on the side of the printed substrate 17. Thus the turning of an offset cam 35 is transmitted through a roller 36 to a rod 39 to set it in fore and aft motion under the counterforce of a spring 38, when the printed substrate 17 is passing through the solder wave 34 in the direction indicated by an arrow K in FIG. 6, then, this motion is transmitted to the printed substrate 17 through a printed substrate conveying means 25 which is supporting the printed substrate 17 and, then, a roller 40, causing the printed substrate 17 to be vibrated from the side at a right angle to the conveying direction. In this way, similar effect as described in connection with the embodiment of FIG. 3 may be achieved.

In this embodiment, only one solder tank nozzle is used, but this invention is applicable to solder tanks having two or more nozzles. With such a device, the vibration should be given to the printed substrate when it passes through one or more nozzles and thereby similar effect is attainable.

Further, while in this embodiment, the printed substrate horizontally moves above the solder tank nozzle, similar effect as in this embodiment is attainable, even when the printed substrate is moved at a slope.

INDUSTRIAL APPLICABILITY

As described in the foregoing, use of this invention makes feasible non-retouched soldering without causing solderlessness in making soldering on a printed substrate, particularly, a printed substrate carrying chip parts. Accordingly, not only the enormous labour required for retouching for soldering is spared, but the chip parts are rescued from damage otherwise they would sustain from the retouching work. Thus this invention's industrial value is quite appreciable.

It should be also noted that as a way of giving vibration to a printed substrate, turning of an offset cam is utilized in this embodiment, but other methods of giving vibration are applicable; for example, the method of using electromagnetic coil or of using an air hammer, etc. Further, while in this embodiment, the vibration is given directly to the printed substrate, similar effect may be achieved by giving vibration to the carrier or pallet which is holding the printed substrate, causing vibration on the printed substrate.

Claims

1. Device for soldering printed circuit boards (17), said device being equipped with a solder tank (14) accommodating molten solder, a nozzle (14a) for forming a molten solder wave (15) by jetting out molten solder from the aforementioned solder tank, a printed circuit board conveying means (25) which effects soldering on the printed circuit board by moving the printed circuit board across the aforementioned molten solder wave, and a vibration imparting means (33) for giving vibration to the aforementioned printed circuit board characterised in that said vibration imparting means is adapted to vibrate said printed circuit board when it is passing across the aforementioned molten solder wave, whereby the solder wave can enter into spaces between chip parts (26, 27) carried on the printed circuit board at a narrow distance from one another.

2. A method of soldering a printed circuit board (17) using a soldering device including a solder tank (14) accommodating molten solder, the method comprising.

forming a molten solder wave (15) by jetting molten solder out of the solder tank (14) via a nozzle (14a); and

conveying the printed circuit board (17) across the solder wave (15) to effect soldering on the printed circuit board;

characterised by vibrating the printed circuit board (17) as it is conveyed across the solder wave (15) whereby the solder wave can enter spaces between chip parts (26, 27) carried on the printed circuit board at a narrow distance from each other.

Patentansprüche

1. Vorrichtung zum Löten von Druckschaltkarten (17), enthaltend einen Lottank (14), der geschmolzenes Lot aufnimmt, eine Düse (14a) zum Bilden einer Welle (15) aus geschmolzenen Lot durch Ausdüsen geschmolzenen Lots aus dem vorgenannten Lottank, eine Druckkartenfördereinrichtung (25), die ein Löten an der Druckschaltkarte durch Bewegen der Druckschaltkarte über die vorerwähnte Welle geschmolzenen Lots ausführt, und eine Schwingungsvermittlungseinrichtung (33), um die vorerwähnte Druckschaltkarte in Schwingung zu versetzen, dadurch gekennzeichnet, daß die Schwingungsvermittlungseinrichtung dazu eingerichtet ist, die Druckschaltkarte in Schwingung zu versetzen, wenn sie über die vorerwähnte Welle aus geschmolzenem Lot läuft, wodurch das Lot in Zwischenräume zwischen Chipteilen (26, 27) eindringen kann, die auf der Druckschaltkarte in engem Abstand gehalten sind.

2. Verfahren zum Löten einer Druckschaltkarte (17) unter Verwendung einer Lötvorrichtung mit einem Lottank (14), der geschmolzenes Lot aufnimmt, enthaltend:

Ausbilden einer Welle (15) geschmolzenen Lots durch Ausdüsen geschmolzenen Lots aus dem Lottank (14) durch eine Düse (14a);

Fördern der Druckschaltkarte (17) über die Lotwelle (15), um ein Löten an der Druckschaltkarte auszuführen;

dadurch gekennzeichnet, daß die Druckschaltkarte (17) in Schwingung versetzt wird, wenn sie über die Lotwelle (15) gefördert wird, wodurch die Lotwelle in Zwischenräume zwischen Chipteilen (26, 27) eindringen kann, die auf der Druckschaltkarte in engem Abstand voneinander gehalten werden.

**Revendications**

1. Dispositif pour souder des cartes de circuit imprimé (17), ledit dispositif étant équipé d'un bac de soudure (14) contenant la soudure en fusion, d'un ajutage (14a) pour former une vague (15) de soudure en fusion en projetant la soudure en fusion à partir de la cuve de soudure précitée, d'un moyen (25) de transport de la carte de circuit imprimé qui réalise la soudure sur la carte du circuit imprimé en déplaçant la carte de circuit imprimé d'un bord à l'autre de la vague de soudure en fusion précitée, ainsi que d'un moyen (33) d'application de vibrations pour donner des vibrations à la carte de circuit imprimé précitée, caractérisé en ce que ledit moyen d'application de vibrations est conçu pour faire vibrer ladite carte de circuit imprimé lorsqu'elle passe d'un bord à l'autre de la vague de soudure en fusion précitée, ce par quoi la vague de soudure peut pénétrer dans les espaces existant entre les microplaquettes (26, 27), portées sur la carte de circuit imprimé, à faible distance l'une de l'autre.

2. Procédé pour souder une carte de circuit imprimé (17) en utilisant un dispositif de soudage comprenant un bac de soudure (14) contenant de la soudure en fusion, le procédé comportant le fait de:

former une vague (15) de soudure en fusion en projetant de la soudure en fusion hors du bac de soudure (14) par l'intermédiaire d'un ajutage (14a); et

transporter la carte de circuit imprimé (17) d'un bord a l'autre de la vague de soudure (15) pour réaliser la soudure sur la carte de circuit imprimé;

caractérisé en ce que l'on fait vibrer la carte de circuit imprimé (17) lorsqu'elle est transportée d'un bond à l'autre de la vague de soudure (15), ce par quoi la vague de soudure peut pénétrer dans les espaces existant entre les microplaquettes (26, 27) portées sur la carte de circuit imprimé, à faible distance l'une de l'autre.

EP 0 119 272 B1

**Fig. 1**

**Fig. 2**

1

**Fig.3**

**Fig.4**

**Fig.5**

# Fig.6

# Fig.7